# FASCICULE DE BREVET EUROPEEN

(11) **EP 3 915 194 B1**
(45) Date de publication et mention de la délivrance du brevet: **19.07.2023**
(21) Numéro de dépôt: 19737574.4
(22) Date de dépôt: 22.01.2019
(51) Int. Cl.: H04B 1/04, H04B 1/18

(54) **PROCÉDÉ ET DISPOSITIF DE DÉTECTION DE PHASE D'UN SIGNAL VIA UN COUPLEUR HYBRIDE, UTILISANT UN SIGNAL DE TEST**
VERFAHREN UND VORRICHTUNG ZUR PHASENDETEKTION EINES SIGNALS ÜBER EINEN HYBRIDKOPPLER UNTER VERWENDUNG EINES TESTSIGNALS
METHOD AND DEVICE FOR PHASE DETECTION OF A SIGNAL VIA A HYBRID COUPLER, USING A TEST SIGNAL

(43) Date de publication de la demande: 01.12.2021
(73) Titulaire: STMICROELECTRONICS SA, 92120 Montrouge (FR); CENTRE NATIONAL DE LA RECHERCHE SCIENTIFIQUE (CNRS), 75016 Paris (FR); Institut Polytechnique de Bordeaux, 33402 Talence Cedex (FR); UNIVERSITE DE BORDEAUX, 33000 Bordeaux (FR)
(72) Inventeur: FOREST, Jeremie, 38190 VILLARD BONNOT (FR); KNOPIK, Vincent, 38830 Crêts en Belledonne (FR); KERHERVE, Eric, 33600 PESSAC (FR)
(74) Mandataire: Casalonga
(86) Numéro de dépôt international: PCT/FR2019/050138
(87) Numéro de publication internationale: WO 2020/152401

(56) Documents cités:
- JP-A- H05 251 965
- US-A1- 2009 103 673
- GERHARD OHM ET AL: "Microwave Phase Detectors for PSK Demodulators", IEEE TRANS. ON MICROWAVE THEORY & TECHNIQUES,, vol. MTT-29, no. 7, 1 juillet 1981 (1981-07-01), pages 724-731, XP001626000, ISSN: 0013-9480

## Description

Des modes de mise en oeuvre et de réalisation de l'invention concernent les dispositifs électroniques, plus particulièrement les dispositifs électroniques de détection de phase.

L'article de GERHARD OHM et al intitulé « Microwave Phase Detectors for PSK Demodulators » IEEE TRANS. ON MICROWAVE THEORY & TECHNIQUES, vol MTT-29, 1 juillet 1981, pages 724-731, XP001626000, décrit un détecteur de phase qui compare les phases de deux signaux périodiques de même fréquence et délivre une tension qui est une mesure de la différence de phase entre les signaux. Ceci est effectué en transformant la différence de phase en une différence ou variation d'amplitude et en mesurant l'amplitude par une détection de pic.

US 2009/103673 A1 décrit, pour améliorer la qualité de transmission de signaux, un combineur de puissance avec une compensation dynamique de phase, qui utilise plusieurs décaleurs de phase pour recevoir deux signaux d'entrée et décaler les phases de ces deux signaux d'entrée.

JP H05 251965 décrit un amplificateur équilibré comprenant un diviseur de puissance divisant un signal d'entrée en deux trajets de signal, deux amplificateurs amplifiant les signaux divisés respectivement, et un combineur de puissance combinant les signaux de sortie des amplificateurs. Un premier circuit de détection de différence de phase détecte une différence de phase entre des signaux des deux trajets de signal du côté de l'entrée de chaque amplificateur. Un deuxième circuit de détection de différence de phase détecte une différence de phase entre les signaux des deux trajets de signal du côté de la sortie de chaque amplificateur. Une section de commande de phase compare les sorties des deux circuits de détection de différence de phase pour générer un signal de commande correspondant à la quantité et à la direction de l'écart de phase provoqué dans chaque amplificateur et un déphaseur corrige la phase du signal dans l'un quelconque des deux trajets de signal en réponse au signal de commande.

D'une façon générale, un dispositif électronique de détection de phase, ou en d'autres termes un détecteur de phase, a pour objectif de générer un signal de sortie proportionnel à la différence de phase entre deux signaux d'entrée.

Un dispositif électronique de détection de phase classique comporte généralement soit des composants analogiques tels que des multiplicateurs analogiques, soit des circuits numériques tels que des portes logiques ou des bascules.

Cependant, un tel dispositif électronique n'est pas conçu de façon adaptée pour des applications électromagnétiques dans le domaine radiofréquence (« Radio Frequency » : RF) notamment dans le domaine de bande millimétrique (« Millimeter band » en langue anglaise).

Il existe ainsi un besoin de proposer une solution technique à faible complexité permettant de détecter la phase d'un signal analogique pour des applications électromagnétiques à très haute fréquence sans apporter de modifications importantes sur les circuits électroniques de ces applications.

Selon un aspect, il est proposé un procédé de détection de la phase d'un signal analogique via un coupleur hybride fonctionnant selon un mode combineur de puissance.

Le coupleur hybride comprend une première entrée destinée à recevoir ledit signal analogique, une deuxième entrée destinée à recevoir un signal analogique supplémentaire déphasé de 90° par rapport au signal analogique, une première sortie délivrant un signal de sortie, et une deuxième sortie,

Le procédé comprenant
une injection à la deuxième sortie d'un signal de test ayant une phase de test initiale,
une génération itérative d'une phase de test courante pour le signal de test, depuis la phase de test initiale jusqu'à une phase de test finale égale à la phase de test initiale augmentée d'au moins une partie d'un tour complet, avec dans chaque itération une mesure de la valeur crête courante du signal de sortie, et une mémorisation de la phase de test courante et de la valeur crête courante en tant que valeur crête maximale ou minimale, s'il n'existe respectivement pas une valeur crête maximale mémorisée plus grande ou une valeur crête minimale mémorisée plus petite que la valeur crête courante, et
une détermination de la phase du signal analogique en fonction de la phase de test mémorisée.

Avantageusement, un tel procédé à la base de l'utilisation d'un coupleur hybride permet une adaptation intrinsèque pour des applications électromagnétiques à très haute fréquence.

En outre, pour des chemins de transmission comportant notamment déjà des coupleurs hybrides, par exemple des amplificateurs de puissance dits équilibrés (« Balanced Power Amplifiers » en langue anglaise), un tel procédé permet avantageusement une solution technique non invasive et à faible complexité.

Grâce à des caractéristiques intrinsèques du coupleur hybride, lorsque le coupleur hybride, fonctionnant selon le mode combineur de puissance, reçoit respectivement aux première et deuxième entrées le signal analogique et le signal analogique supplémentaire déphasé de 90° par rapport au signal analogique, on obtient à l'une des première et deuxième sorties un signal de sortie ayant une puissance égale à la combinaison des puissances du signal analogique et du signal analogique supplémentaire, autrement dit deux fois la puissance du signal analogique, si l'autre des première et deuxième sorties est couplée à une impédance résistive, par exemple de 50 ohms.

Si l'autre des première et deuxième sorties est destinée à recevoir un autre signal analogique, ici par exemple un signal de test, au lieu de l'impédance de 50 ohms, l'amplitude du signal de sortie varie en fonction de la phase du signal de test.

Lorsque la phase du signal de test est égale à celle du signal analogique, l'amplitude du signal de sortie atteint sa valeur maximale.

En d'autres termes, lorsque la valeur crête du signal de sortie atteint sa valeur maximale, la phase du signal de test correspondant à cette valeur crête maximale est sensiblement égale à celle du signal analogique.

A contrario, lorsque la phase du signal de test est sensiblement égale à celle du signal analogique diminuée de 180°, la valeur crête correspondante du signal de sortie atteint sa valeur minimale.

Ainsi, selon un mode de mise en oeuvre, la phase du signal analogique est égale à la phase de test mémorisée si la phase de test mémorisée correspond à la valeur crête maximale mémorisée, ou à la phase de test mémorisée augmentée de 180° si la phase de test mémorisée correspond à la valeur crête minimale mémorisée.

A titre indicatif non limitatif, la phase de test finale peut être la phase de test initiale augmentée d'un tour complet.

Selon un autre aspect, il est proposé un procédé de réglage de la phase d'un signal analogique via un coupleur hybride fonctionnant selon un mode de combineur de puissance.

Ce procédé de réglage comprend
une détermination de la phase du signal analogique par application du procédé tel que défini ci-avant,
une comparaison entre une phase de consigne et la phase du signal analogique, et
si la phase de consigne et la phase du signal analogique sont différentes, un réglage, de la phase du signal analogique jusqu'à obtenir une égalité entre la phase de consigne et la phase du signal analogique à une tolérance près.

Il convient de noter que l'homme du métier saura choisir une tolérance adaptée en fonction par exemple de l'application envisagée. A titre indicatif mais non limitatif, ladite tolérance peut par exemple être de l'ordre de 5 à 10%.

Selon un autre aspect, il est proposé un dispositif électronique de détection de la phase d'un signal analogique.

Ce dispositif comprend
un coupleur hybride configuré pour fonctionner selon un mode combineur de puissance et comprenant une première entrée destinée à recevoir le signal analogique, une deuxième entrée destinée à recevoir un signal analogique déphasé de 90° par rapport au signal analogique, une première sortie destinée à délivrer un signal de sortie, et une deuxième sortie,
des moyens de détection configurés pour
injecter à la deuxième sortie un signal de test ayant une phase de test initiale,
effectuer une génération itérative d'une phase de test courante pour le signal de test, depuis la phase de test initiale jusqu'à une phase de test finale égale à la phase de test initiale jusqu'à une phase de test finale égale à la phase de test initiale augmentée d'au moins une partie d'un tour complet, avec dans chaque itération une mesure de la valeur crête courante du signal de sortie, et une mémorisation de la phase de test courante et de la valeur crête courante en tant que valeur crête maximale ou minimale, s'il n'existe respectivement pas une valeur crête maximale mémorisée plus grande ou une valeur crête minimale mémorisée plus petite que la valeur crête courante, et
déterminer la phase du signal analogique en fonction de la phase de test mémorisée.

Selon un mode de réalisation, la phase du signal analogique est égale
à la phase de test mémorisée si la phase de test mémorisée correspond à la valeur crête maximale mémorisée, ou
à la phase de test mémorisée augmentée de 180° si la phase de test mémorisée correspond à la valeur crête minimale mémorisée.

Selon un autre mode de réalisation, la phase de test finale est la phase de test initiale augmentée d'un tour complet.

Selon un autre aspect, il est proposé un dispositif de réglage de la phase d'un signal analogique via un coupleur hybride configuré pour fonctionner selon un mode combineur de puissance, comprenant un dispositif de détection de la phase du signal analogique tel que défini ci-avant configuré pour déterminer la phase du signal analogique, et
des moyens de réglage couplés au coupleur hybride, et configurés pour délivrer à la première entrée le signal analogique, à la deuxième entrée le signal analogique supplémentaire, et aux moyens de détection un signal de consigne ayant une phase de consigne,
les moyens de détection étant en outre configurés pour
comparer la phase de consigne et la phase du signal analogique déterminée, et
si la phase de consigne et la phase du signal analogique déterminée sont différentes, régler la phase du signal analogique via les moyens de réglage jusqu'à obtenir une égalité entre la phase de consigne et la phase du signal analogique déterminée à une tolérance près.

Selon un mode de réalisation, les moyens de réglage comprennent un coupleur hybride complémentaire configuré pour fonctionner selon un mode de diviseur de puissance et couplé aux première et deuxième entrées du coupleur hybride.

Selon un autre mode de réalisation, les moyens de réglage comprennent un coupleur hybride complémentaire configuré pour fonctionner selon un mode de diviseur de puissance et couplé aux première et deuxième entrées du coupleur hybride via un étage de couplage.

Selon un autre aspect, il est proposé un chemin de transmission, comprenant
un dispositif électronique de détection tel que défini ci-avant ou un dispositif électronique de réglage tel que défini ci-dessus, et
une antenne couplée au coupleur hybride.

Selon encore un autre aspect, il est proposé un appareil de communication incorporant au moins un chemin de transmission tel que défini ci-dessus.

D'autres avantages et caractéristiques de l'invention apparaîtront à l'examen de la description détaillée de modes de mise en oeuvre et de réalisation, nullement limitatifs, et des dessins annexés sur lesquels :

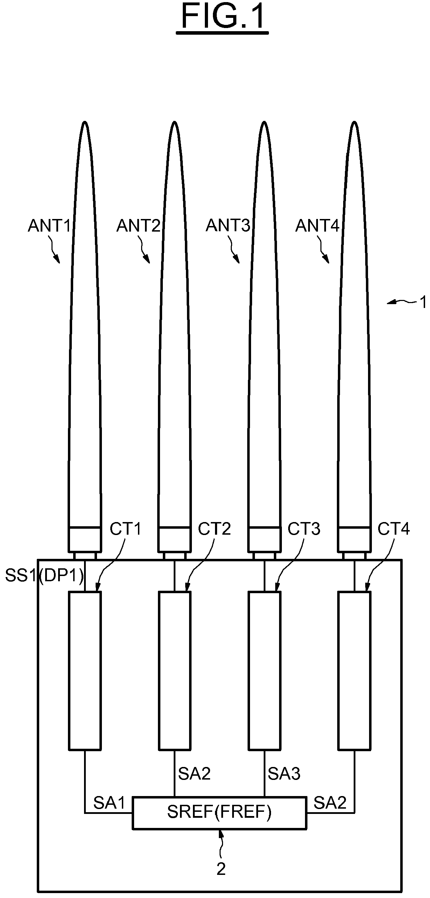

- les figures 1 à 5 illustrent schématiquement des modes de mise en oeuvre et de réalisation de l'invention.

La figure 1 illustre un appareil de communication 1, ici par exemple un appareil de communication du type routeur Wi-Fi conformément aux normes du groupe IEEE 802.11.

A titre d'exemple non limitatif, ce routeur 1 est basé ici sur la technologie de la formation de faisceaux (« Beamforming » en langue anglaise), communément connue de l'homme du métier, pour l'émission directionnelle de signaux.

Ce routeur 1 comporte
un module d'émission 2, ici par exemple un émetteur-récepteur 2 configuré pour générer N signaux analogiques SA1, SA2, SA3, SA4 (N est un nombre entier égal ou supérieur à deux, ici N est par exemple égal à 4), et
N antennes ANT1, ANT2, ANT3, ANT4 couplées respectivement à l'émetteur-récepteur 2 via 4 chemins de transmission CT1, CT2, CT3, CT4.

Chaque signal analogique SA1, SA2, SA3, SA4 est généré à partir d'un signal de référence SREF ayant une fréquence de référence FREF et chaque signal analogique SA1, SA2, SA3, SA4 est destiné à avoir un déphasage prédéterminé par rapport au signal de référence SREF.

En général, l'émetteur-récepteur 2 est configuré pour contrôler la phase et l'amplitude relatives de chaque signal analogique SA1, SA2, SA3, SA4 dédié au chemin de transmission CT1, CT2, CT3, CT4 correspondant.

Après traitements de signaux effectués par chaque chemin de transmission CT1, CT2, CT3, CT4, chaque antenne ANT1, ANT2, ANT3, ANT4 est configurée pour émettre un signal de sortie SS1, SS2, SS3, SS4 correspondant ayant un déphasage prédéterminé DP1, DP2, DP3, DP4 correspondant.

En conséquence, un motif d'interférences constructives et destructives peut être formé dans le front d'onde. À la réception, l'information provenant des différentes antennes ANT1, ANT2, ANT3, ANT4 est combinée de telle manière que le signal attendu soit mis en évidence.

Il convient de noter que la performance de l'émission directionnelle de ces signaux de sortie SS1, SS2, SS3, SS4 dépend fortement de la précision des déphasages DP1, DP2, DP3, DP4 de ces signaux de sortie SS1, SS2, SS3, SS4.

De ce fait, il est requis, pour chaque chemin de transmission CT1, CT2, CT3, CT4, une détection et éventuellement un réglage du déphasage DP1, DP2, DP3, DP4 du signal de sortie SS1, SS2, SS3, SS4 de façon à assurer la performance de l'émission directionnelle.

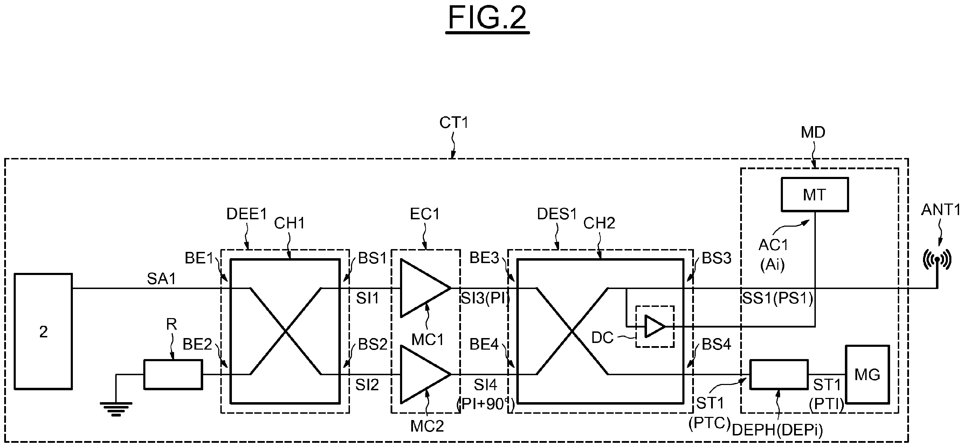

On se réfère maintenant à la figure 2 pour illustrer plus en détails un exemple de réalisation d'un des chemins de transmission CT1, CT2, CT3, CT4, ici par exemple le premier chemin de transmission CT1, du routeur 1.

Le premier chemin de transmission CT1 est couplé entre l'émetteur-récepteur 2 et la première antenne ANT1 et comporte
un dispositif électronique d'entrée DEE1 couplé à l'émetteur-récepteur 2, et
un dispositif électronique de sortie DES1 couplé à la première antenne ANT1.

A titre d'exemple non limitatif, le premier chemin de transmission CT1 comporte en outre un étage de couplage EC1 couplé entre les dispositifs électroniques d'entrée DEE1 et de sortie DES1. A des fins de simplification, on n'illustre qu'un exemple de réalisation de l'étage de couplage EC1.

L'ensemble des dispositifs électroniques d'entrée DEE1 et de sortie DES1 et de l'étage de couplage EC1 forme un amplificateur de puissance équilibré (« Balanced Power Amplifier » en langue anglaise).

Le dispositif électronique d'entrée DEE1 comporte un premier coupleur hybride CH1, ici par exemple un coupleur hybride 90° en quadrature, comportant
une première borne d'entrée BE1 couplée à l'émetteur-récepteur 2 et destinée à recevoir le premier signal analogique SA1,
une deuxième borne d'entrée BE2 couplée, dite « isolée », couplée à une impédance R, par exemple de 50 ohms, lorsque le coupleur fonctionne en mode diviseur de puissance, ou dite « couplée » lorsque le coupleur fonctionne en mode combineur de puissance,
une première borne de sortie BS1, et
une deuxième borne de sortie BS2.

Le dispositif électronique d'entrée DDE1 est configuré pour délivrer
à la première borne de sortie BS1, un premier signal intermédiaire SI1 ayant une puissance égale à la moitié de la puissance du premier signal analogique SA1, et
à la deuxième borne de sortie BS2, un deuxième signal intermédiaire SI2 ayant la même puissance que le premier signal intermédiaire SI1 et ayant un déphasage de 90° par rapport au premier signal intermédiaire SI1.

Le dispositif électronique de sortie DES1 comporte un deuxième coupleur hybride CH2, ici aussi un coupleur hybride 90° en quadrature, fonctionnant en mode combineur de puissance et comportant
une troisième borne d'entrée BE3,
une quatrième borne d'entrée BE4,
une troisième borne de sortie BS3 couplée à la première antenne ANT1 et configurée pour délivrer à la première antenne ANT1 le premier signal de sortie SS1, et
une quatrième borne de sortie BS4.

La quatrième borne de sortie BS4 est destinée à
être couplée, lorsque le dispositif électronique de sortie DES1 est dans un mode de fonctionnement, à une impédance par exemple de 50 ohms, et
recevoir, lorsque le dispositif électronique de sortie DES1 est dans un mode de détection ou de réglage, un premier signal de test ST1.

A titre indicatif mais non limitatif, lorsque le premier chemin de transmission CT1 est en fonctionnement, le premier coupleur hybride CH1 fonctionne en mode diviseur de puissance et le deuxième coupleur hybride CH2 fonctionne en mode combineur de puissance.

L'étage de couplage EC1 comporte
un premier module de couplage MC1 couplé en parallèle entre la première borne de sortie BS1 et la troisième borne d'entrée BE3, et
un deuxième module de couplage MC2 couplé en parallèle entre la deuxième borne de sortie BS2 et la quatrième borne d'entrée BE4.

Le premier module de couplage MC1 comprend ici par exemple un premier étage de pilotage (« driver stage » en anglais) et un premier contrôleur de puissance couplés en série entre la première borne de sortie BS1 et la troisième borne d'entrée BE3.

Le premier module de couplage MC1 est configuré pour délivrer à partir du premier signal intermédiaire SI1 un troisième signal intermédiaire SI3 ayant une phase intermédiaire PI.

Le deuxième module de couplage MC2 comporte un deuxième étage de pilotage et un deuxième contrôleur de puissance couplés en série entre la deuxième borne de sortie BS2 et la quatrième borne d'entrée BE4.

Le deuxième module de couplage MC2 est configuré pour délivrer à partir du deuxième signal intermédiaire SI2 un quatrième signal intermédiaire SI4 ayant un déphasage de 90° par rapport à la phase du troisième signal intermédiaire SI3.

Afin d'assurer la phase du premier signal de sortie SS1 délivré à la première antenne ANT1, le premier chemin de transmission CT1 est en outre configuré pour détecter et régler la phase du premier signal de sortie SS1. Il convient de noter que cette phase du premier signal de sortie SS1 est sensiblement égale à celle du troisième signal intermédiaire SI3.

Pour ce faire, le dispositif électronique de sortie DES1 comprend en outre des moyens de détection MD comportant
un détecteur de crête DC couplé à la troisième borne de sortie BS3 et configuré pour détecter la valeur crête VC du premier signal de sortie SS1,
des moyens de génération MG configurés pour générer le premier signal de test ST1,
un déphaseur DEPH couplé entre la quatrième borne de sortie BS4 et les moyens de génération MG et configuré pour modifier la phase de test du premier signal de test ST1, et
des moyens de traitement MT couplé au détecteur de crête DC et aux déphaseur DEPH, et configurés pour détecter la valeur crête maximale ou minimale du premier signal de sortie SS1 en faisant varier la phase du premier signal de test ST1 de façon à détecter la phase PI du troisième signal intermédiaire SI3.

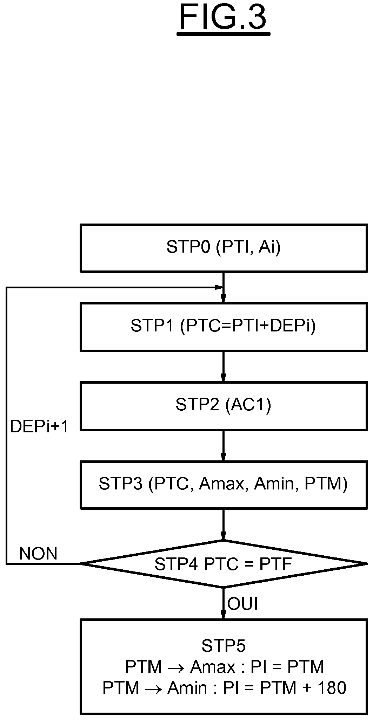

Il convient de se référer maintenant à la figure 3 pour illustrer un exemple de mise en oeuvre permettant de détecter et régler la phase PI du troisième signal intermédiaire SI3, autrement dit la première phase de sortie PS1 du premier signal de sortie SS1 lorsque le deuxième coupleur hybride CH2 fonctionne en mode combineur de puissance.

Dans une étape initiale STP0, le déphaseur DEPH est configuré pour injecter le signal de test ST à la quatrième borne de sortie BS4 sans modifier la phase de test initiale PTI et le détecteur de crête DC est configuré pour détecter une valeur crête initiale Ai.

Les étapes STP1 à STP4 sont des étapes itératives. Dans chaque itération, on commence par une étape STP1 dans laquelle le déphaseur DEPH est configuré pour générer une phase de test courante PTC du premier signal de test ST1 en appliquant un déphasage DEPi au premier signal de test ST1.

Il convient de noter que ledit déphasage peut par exemple être pour chaque itération, une incrémentation ou une décrémentation d'une phase donnée, par exemple de 5°, sur le premier signal de test ST1 et que les itérations se terminent lorsque la phase de test courante atteint une phase de test finale PTF égale à la phase de test initiale PTI augmentée d'au moins une partie d'un tour complet.

A des fins de simplification, la phase de test finale PTF est ici par exemple égale à la phase de test initiale PTI augmentée d'un tour complet, soit 360°.

Le détecteur de crête DC est ensuite configuré pour mesurer, dans chaque itération, la valeur crête courante AC1 du premier signal de sortie SS1 (STP2).

Les moyens de traitement MT sont configurés pour vérifier s'il existe respectivement une valeur crête maximale mémorisée Amax plus grande ou une valeur crête minimale Amin mémorisée plus petite que la valeur crête courante AC1.

Si cela est le cas, cette itération courante se termine et une nouvelle itération va démarrer avec un déphasage DEPi+1 différent.

Sinon, les moyens de traitement MT sont configurés pour mémoriser la phase de test courante PTC et la valeur crête courante AC1 en tant que valeur crête maximale Amax ou minimale Amin (STP3).

Autrement dit, si la valeur crête courante AC1 est plus grande que la valeur crête maximale mémorisée Amax, cette valeur crête courante AC1 est mémorisée en tant que valeur crête maximale Amax et ladite phase de test courante PTC correspondant à cette valeur crête courante AC1 est également mémorisée.

Si la valeur crête courante AC1 est plus petite que la valeur crête minimale mémorisée Amin, cette valeur crête courante AC1 est mémorisée en tant que valeur crête minimale Amin et ladite phase de test courante PTC correspondant à cette valeur crête courante AC1 est également mémorisée.

Dans le cas de la première itération après l'étape STP0, comme la valeur crête initiale Ai n'est pas mémorisée, la valeur crête courante AC1 est mémorisée en tant que valeur crête maximale Amax ou valeur crête minimale Amin et ladite phase de test courante PTC correspondant à cette valeur crête courante AC1 est également mémorisée.

Une fois que la phase de test courante PTC atteint ladite phase de test initiale PTI (STP4 sur la figure 3), ici par exemple la phase de test initiale augmentée d'un tour complet soit 360°, les itérations se terminent et les moyens de traitement MT sont en outre configurés pour déterminer la phase PI du troisième signal intermédiaire SI3, autrement dit la première phase de sortie PS1 du premier signal de sortie SS1 lorsque le deuxième coupleur hybride CH2 fonctionne en mode combineur de puissance, en fonction de la phase de test mémorisée PTM.

La phase PI du troisième signal intermédiaire SI3 est égale à la phase de test mémorisée PTM si la phase de test mémorisée PTM correspond à la valeur crête maximale Amax mémorisée, ou à la phase de test mémorisée PTM ajoutée de 180° si la phase de test mémorisée PTM correspond à la valeur crête minimale Amin mémorisée (STP5 sur la figure 3).

Il convient de noter que la précision de la détection de la phase intermédiaire PI dépend des pas de variation (« variation step » en langue anglaise) du déphasage DEPi du premier signal de test ST1 dans chaque itération. Plus le pas de variation est fin, plus la précision de la détection est élevée.

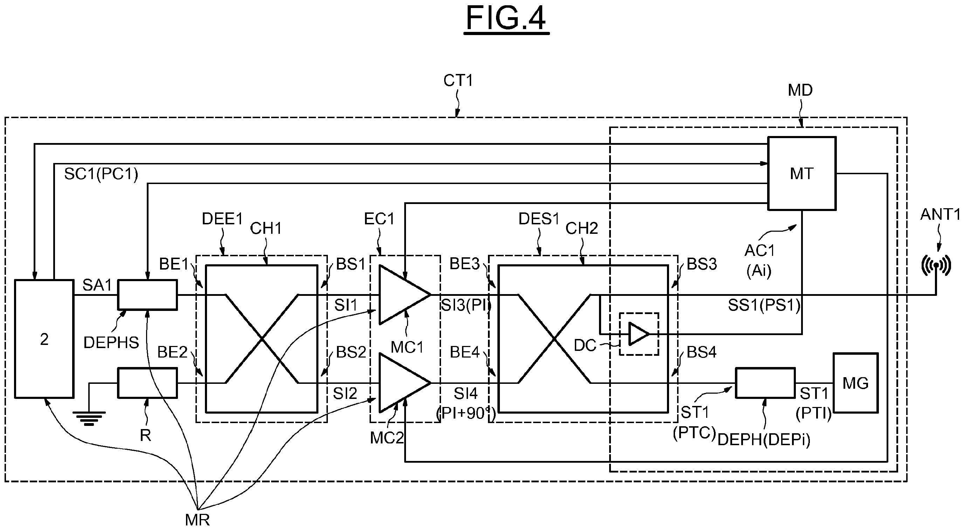

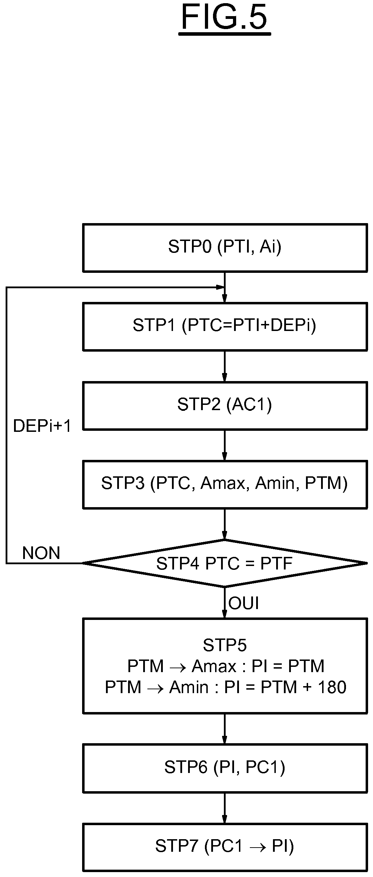

On se réfère maintenant à la figure 4 pour illustrer un exemple de réalisation permettant de régler la phase d'un signal analogique via un coupleur hybride et à la figure 5 pour illustrer un exemple de mise en oeuvre correspondant.

A des fins de simplification, on retrouve l'émetteur-récepteur 2, le premier chemin de transmission CT1 et la première antenne ANT1 déjà présentés sur la figure 2.

Par ailleurs, les moyens de détection MD sont en outre couplés à des moyens de réglage MR.

Les moyens de réglage MR comportent ici l'émetteur-récepteur 2 configuré pour délivrer aux moyens de traitement MT un premier signal de consigne SC1 ayant une première phase de consigne PC1, le premier coupleur hybride CH1, et l'étage de couplage EC1.

Comme indiqué ci-avant, pour la détection et le réglage de la phase intermédiaire PI du troisième signal intermédiaire SI3, l'étage de couplage EC1 est ici optionnel et les moyens de réglage MR peuvent ne pas comporter l'étage de couplage EC1.

Dans ce cas-là, les premier et troisième signaux intermédiaires SI1, SI3 sont les mêmes signaux et les deuxième et quatrième signaux intermédiaires SI2, SI4 sont les mêmes signaux.

A titre indicatif mais non limitatif, il est possible d'avoir un routeur comportant un chemin de transmission ayant des moyens de réglage et un autre chemin de transmission sans moyens de réglage.

A des fins de simplification, on n'illustre sur la figure 5 qu'un exemple de réalisation de l'invention comportant les moyens de réglage MR avec l'étage de couplage EC1.

Une fois la phase PI du troisième signal intermédiaire SI déterminée en suivant les étapes STP0 à STP5, les moyens de traitement MT sont en outre configurés pour comparer ladite phase intermédiaire PI avec la première phase de consigne PC1 (STP6 sur la figure 5).

Lorsque la phase intermédiaire PI et la première phase de consigne PC1 sont différentes, l'émetteur-récepteur 2 est en outre configuré pour régler sous contrôle des moyens de traitement MT la phase intermédiaire PI du troisième signal intermédiaire via un réglage de la phase du premier signal analogique SA1 jusqu'à obtenir une égalité entre la première phase de consigne PC1 et ladite phase intermédiaire PI à une tolérance près (STP7 sur la figure 5).

A titre indicatif mais non limitatif, ladite tolérance peut par exemple ici être de l'ordre de 5%.

Selon une variante, les moyens de réglage MR peuvent comporter en outre un déphaseur supplémentaire DEPHS couplé entre l'émetteur-récepteur 2 et le premier coupleur hybride CH1 et configuré pour régler sous contrôle des moyens de traitement MT la phase PI du troisième signal intermédiaire via un réglage de la phase du premier signal analogique SA1 jusqu'à obtenir une égalité entre la première phase de consigne PC1 et ladite phase PI à une tolérance près (STP7 sur la figure 5).

Il convient de noter que ledit réglage de la phase PI ne peut être effectué que par le déphaseur supplémentaire DEPHS ou en combinaison avec l'émetteur-récepteur 2.

Selon une autre variante, les moyens de réglage MR peuvent comporter en outre les premier et deuxième modules de couplage MC1, MC2.

Le premier module de couplage MC1 est configuré pour régler sous contrôle des moyens de traitement MT la phase PI du troisième signal intermédiaire SI3 jusqu'à obtenir une égalité entre la première phase de consigne PC1 et ladite phase intermédiaire PI à une tolérance près (STP7 sur la figure 5).

Le deuxième module de couplage MC1 est configuré pour régler sous contrôle des moyens de traitement MT la phase du quatrième signal intermédiaire SI4 jusqu'à obtenir une égalité entre la première phase de consigne PC1 déphasé de 90° et ladite phase du quatrième signal intermédiaire SI4 à une tolérance près (STP7 sur la figure 5).

Il convient de noter également que le réglage de la phase PI peut être effectué par le troisième module de couplage MC3 tout seul ou en combinaison avec le déphaseur supplémentaire DEPHS et/ou l'émetteur-récepteur 2.

Ainsi, on obtient une solution technique à faible complexité pour détecter et régler la phase d'un signal analogique en utilisant un coupleur hybride, ce qui est particulièrement adapté pour des applications électromagnétiques dans le domaine radiofréquence (« Radio Frequency » : RF) notamment dans le domaine de bande millimétrique (« Millimeter band » en langue anglaise).

## Revendications

1. Procédé de détection d'une phase (PI) d'un signal analogique (SI3) via un coupleur hybride (CH2) fonctionnant selon un mode combineur de puissance, le coupleur hybride (CH2) comprenant une première entrée (BE3) destinée à recevoir ledit signal analogique (SI3), une deuxième entrée (BE4) destinée à recevoir un signal analogique supplémentaire (SI4) déphasé de 90° par rapport au signal analogique (SI3), une première sortie (BS3) délivrant un signal de sortie (SS1), et une deuxième sortie (BS4), le procédé étant **caractérisé en ce qu'**il comprend:
une injection à la deuxième sortie (BS4) d'un signal de test (ST1) ayant une phase de test initiale (PTI),
une génération itérative d'une phase de test courante (PTC) pour le signal de test (ST1), depuis la phase de test initiale (PTI) jusqu'à une phase de test finale (PTF) égale à la phase de test initiale (PTI) augmentée d'au moins une partie d'un tour complet, avec dans chaque itération une mesure de la valeur crête courante (AC1) du signal de sortie (SS1), et une mémorisation de la phase de test courante (PTC) et de la valeur crête courante (AC1) en tant que valeur crête maximale (Amax) ou minimale (Amin), s'il n'existe respectivement pas une valeur crête maximale (Amax) mémorisée plus grande ou une valeur crête minimale (Amin) mémorisée plus petite que la valeur crête courante (AC1), et
une détermination de la phase (PI) du signal analogique (SI3) à partir de la phase de test mémorisée (PTM).

2. Procédé selon la revendication 1, dans lequel la phase (PI) du signal analogique (SI3) est égale
à la phase de test mémorisée (PTM) si la phase de test mémorisée (PTM) correspond à la valeur crête maximale (Amax) mémorisée, ou
à la phase de test mémorisée (PTM) augmentée de 180° si la phase de test mémorisée (PTM) correspond à la valeur crête minimale (Amin) mémorisée.

3. Procédé selon la revendication 1 ou 2, dans lequel la phase de test finale (PTF) est la phase de test initiale (PTI) augmentée d'un tour complet.

4. Procédé de réglage de la phase (PI) d'un signal analogique (SI3) via un coupleur hybride (CH2) fonctionnant selon un mode combineur de puissance, comprenant
une détermination de la phase (PI) du signal analogique (SI3) par application du procédé selon l'une quelconque des revendications précédentes,
une comparaison entre une phase de consigne (PC1) et la phase (PI) du signal analogique (SI3), et
si la phase de consigne (PC1) et la phase (PI) du signal analogique (SI3) déterminée sont différentes, un réglage de la phase du signal analogique (SI3) jusqu'à obtenir une égalité entre la phase de consigne (PC1) et la phase (PI) du signal analogique (SI3) à une tolérance près.

5. Dispositif électronique de détection d'une phase (PI) d'un signal analogique (SI3), comprenant
un coupleur hybride (CH2) configuré pour fonctionner selon un mode combineur de puissance et comprenant une première entrée (BE3) destinée à recevoir le signal analogique (SI3), une deuxième entrée (BE4) destinée à recevoir un signal analogique supplémentaire (SI4) déphasé de 90° par rapport au signal analogique, une première sortie (BS3) destinée à délivrer un signal de sortie (SS1), et une deuxième sortie (BS4), le dispositif étant **caractérisé en ce qu'**il comprend en outre des moyens de détection (MD) configurés pour
injecter à la deuxième sortie (BS4) un signal de test (ST1) ayant une phase de test initiale (PTI),
effectuer une génération itérative d'une phase de test courante (PTC) pour le signal de test (ST1), depuis la phase de test initiale (PTI) jusqu'à une phase de test finale (PTF) égale à la phase de test initiale (PTI) augmentée d'au moins une partie d'un tour complet, avec dans chaque itération une mesure de la valeur crête courante (AC1) du signal de sortie (SS1), et une mémorisation de la phase de test courante (PTC) et de la valeur crête courante (AC1) en tant que valeur crête maximale (Amax) ou minimale (Amin), s'il n'existe respectivement pas une valeur crête maximale (Amax) mémorisée plus grande ou une valeur crête minimale (Amin) mémorisée plus petite que la valeur crête courante (AC1), et
déterminer la phase (PI) du signal analogique (SI3) en fonction de la phase de test mémorisée (PTM).

6. Dispositif selon la revendication 5, dans lequel la phase (PI) du signal analogique (SI3) est égale
à la phase de test mémorisée (PTM) si la phase de test mémorisée (PTM) correspond à la valeur crête maximale (Amax) mémorisée, ou
à la phase de test mémorisée (PTM) augmentée de 180° si la phase de test mémorisée (PTM) correspond à la valeur crête minimale (Amin) mémorisée.

7. Dispositif selon la revendication 5 ou 6, dans lequel la phase de test finale (PTF) est la phase de test initiale (PTI) augmentée d'un tour complet.

8. Dispositif de réglage de la phase (PI) d'un signal analogique (SI3) via un coupleur hybride (CH2) fonctionnant selon un mode combineur de puissance, comprenant
un dispositif de détection (CH2, MD) selon l'une quelconque des revendications 5 à 7 configuré pour déterminer la phase (PI) du signal analogique (SI3), et
des moyens de réglage (MR) couplés au coupleur hybride (CH2), et configurés pour délivrer à la première entrée (BE3) le signal analogique (SI3), à la deuxième entrée (BE4) le signal analogique supplémentaire (SI4), et aux moyens de détection (MD) un signal de consigne (SC1) ayant une phase de consigne (PC1),
les moyens de détection (MD) étant en outre configurés pour
comparer la phase de consigne (PC1) et la phase (PI) du signal analogique (SI3) déterminée, et
si la phase de consigne (PC1) et la phase (PI) du signal analogique (SI3) déterminée sont différentes, régler la phase du signal analogique (SI3) via les moyens de réglage (MR) jusqu'à obtenir une égalité entre la phase de consigne (PC1) et la phase (PI) du signal analogique (SI3) déterminée à une tolérance près.

9. Dispositif selon la revendication 8, dans lequel les moyens de réglage (MR) comprennent un coupleur hybride complémentaire (CH1) configuré pour fonctionner selon un mode de diviseur de puissance et couplé aux première et deuxième entrées (BE3, BE4) du coupleur hybride (CH2).

10. Dispositif selon la revendication 8, dans lequel les moyens de réglage (MR) comprennent un coupleur hybride complémentaire (CH1) configuré pour fonctionner selon un mode de diviseur de puissance et couplé aux première et deuxième entrées (BE3, BE4) du coupleur hybride (CH2) via un étage de couplage (EC1).

11. Chemin de transmission, comprenant
un dispositif électronique de détection (CH1, MD) selon l'une quelconque des revendications 5 à 7 ou un dispositif électronique de réglage (CH1, MD, CH2, MR) selon l'une quelconque des revendications 8 à 10, et
une antenne (ANT1) couplée au coupleur hybride (CH2).

12. Appareil de communication incorporant au moins un chemin de transmission (CT1) selon la revendication 11.

## Patentansprüche

1. Verfahren zur Detektion einer Phase (PI) eines analogen Signals (SI3) über einen Hybridkoppler (CH2), der nach einem Leistungskombinierermodus arbeitet, wobei der Hybridkoppler (CH2) einen ersten Eingang (BE3), der dazu bestimmt ist, das analoge Signal (SI3) zu empfangen, einen zweiten Eingang (BE4), der dazu bestimmt ist, ein zusätzliches analoges Signal (SI4) zu empfangen, das in Bezug auf das analoge Signal (SI3) um 90° phasenverschoben ist, einen ersten Ausgang (BS3), der ein Ausgangssignal (SS1) liefert, und einen zweiten Ausgang (BS4) umfasst, wobei das Verfahren **dadurch gekennzeichnet** ist, das es umfasst:
Einspeisen eines Testsignals (ST1) mit einer anfänglichen Testphase (PTI) am zweiten Ausgang (BS4),
iteratives Erzeugen einer aktuellen Testphase (PTC) für das Testsignal (ST1) ausgehend von der anfänglichen Testphase (PTI) bis zu einer abschließenden Testphase (PTF), die gleich der anfänglichen Testphase (PTI) plus mindestens einem Teil einer vollständigen Drehung ist, mit, bei jeder Iteration, einer Messung des aktuellen Spitzenwerts (AC1) des Ausgangssignals (SS1) und einer Speicherung der aktuellen Testphase (PTC) und des aktuellen Spitzenwerts (AC1) als maximaler (Amax) oder minimaler Spitzenwert (Amin), wenn es keinen gespeicherten maximalen Spitzenwert (Amax), der größer ist, bzw. keinen gespeicherten minimalen Spitzenwert (Amin) gibt, der kleiner ist als der aktuelle Spitzenwert (AC1), und
Bestimmen der Phase (PI) des analogen Signals (SI3) anhand der gespeicherten Testphase (PTM).

2. Verfahren nach Anspruch 1, wobei die Phase (PI) des analogen Signals (SI3) gleich
der gespeicherten Testphase (PTM) ist, wenn die gespeicherte Testphase (PTM) dem gespeicherten maximalen Spitzenwert (Amax) entspricht, oder
der gespeicherten Testphase (PTM) plus 180° ist, wenn die gespeicherte Testphase (PTM) dem gespeicherten minimalen Spitzenwert (Amin) entspricht.

3. Verfahren nach Anspruch 1 oder 2, wobei es sich bei der abschließenden Testphase (PTF) um die anfängliche Testphase (PTI) plus einer vollständigen Drehung handelt.

4. Verfahren zum Einstellen der Phase (PI) eines analogen Signals (SI3) über einen Hybridkoppler (CH2), der nach einem Leistungskombinierermodus arbeitet, umfassend Bestimmen der Phase (PI) des analogen Signals (SI3) durch Anwenden des Verfahrens nach einem der vorstehenden Ansprüche,
Vergleichen einer Soll-Phase (PC1) und der Phase (PI) des analogen Signals (SI3), und
wenn sich die Soll-Phase (PC1) und die bestimmte Phase (PI) des analogen Signals (SI3) unterscheiden, Einstellen der Phase des analogen Signals (SI3), bis eine Gleichheit der Soll-Phase (PC1) und der Phase (PI) des analogen Signals (SI3) bis auf eine Toleranz erhalten wird.

5. Elektronische Vorrichtung zur Detektion einer Phase (PI) eines analogen Signals (SI3), umfassend
einen Hybridkoppler (CH2), der konfiguriert ist, um nach einem Leistungskombinierermodus zu arbeiten, und einen ersten Eingang (BE3), der dazu bestimmt ist, das analoge Signal (SI3) zu empfangen, einen zweiten Eingang (BE4), der dazu bestimmt ist, ein zusätzliches analoges Signal (SI4) zu empfangen, das in Bezug auf das analoge Signal um 90° phasenverschoben ist, einen ersten Ausgang (BS3), der dazu bestimmt ist, ein Ausgangssignal (SS1) zu liefern, und einen zweiten Ausgang (BS4) umfasst,
wobei die Vorrichtung **dadurch gekennzeichnet ist, dass** sie weiter umfasst
Detektionsmittel (MD), die konfiguriert sind, um
am zweiten Ausgang (BS4) ein Testsignal (ST1) mit einer anfänglichen Testphase (PTI) einzuspeisen,
ein iteratives Erzeugen einer aktuellen Testphase (PTC) für das Testsignal (ST1) ausgehend von der anfänglichen Testphase (PTI) bis zu einer abschließenden Testphase (PTF), die gleich der anfänglichen Testphase (PTI) plus mindestens einem Teil einer vollständigen Drehung ist, vorzunehmen, mit, bei jeder Iteration, einer Messung des aktuellen Spitzenwerts (AC1) des Ausgangssignals (SS1) und einer Speicherung der aktuellen Testphase (PTC) und des aktuellen Spitzenwerts (AC1) als maximaler (Amax) oder minimaler Spitzenwert (Amin), wenn es keinen gespeicherten maximalen Spitzenwert (Amax), der größer ist, bzw. keinen gespeicherten minimalen Spitzenwert (Amin) gibt, der kleiner ist als der aktuelle Spitzenwert (AC1), und
die Phase (PI) des analogen Signals (SI3) in Abhängigkeit von der gespeicherten Testphase (PTM) zu bestimmen.

6. Vorrichtung nach Anspruch 5, wobei die Phase (PI) des analogen Signals (SI3) gleich
der gespeicherten Testphase (PTM) ist, wenn die gespeicherte Testphase (PTM) dem gespeicherten maximalen Spitzenwert (Amax) entspricht, oder
der gespeicherten Testphase (PTM) plus 180° ist, wenn die gespeicherte Testphase (PTM) dem gespeicherten minimalen Spitzenwert (Amin) entspricht.

7. Vorrichtung nach Anspruch 5 oder 6, wobei es sich bei der abschließenden Testphase (PTF) um die anfängliche Testphase (PTI) plus einer vollständigen Drehung handelt.

8. Vorrichtung zum Einstellen der Phase (PI) eines analogen Signals (SI3) über einen Hybridkoppler (CH2), der nach einem Leistungskombinierermodus arbeitet, umfassend
eine Detektionsvorrichtung (CH2, MD) nach einem der Ansprüche 5 bis 7, die konfiguriert ist, um die Phase (PI) des analogen Signals (SI3) zu bestimmen, und Einstellmittel (MR), die mit dem Hybridkoppler (CH2) gekoppelt und konfiguriert sind, um dem ersten Eingang (BE3) das analoge Signal (SI3), dem zweiten Eingang (BE4) das zusätzliche analoge Signal (SI4), und den Detektionsmitteln (MD) ein Soll-Signal (SC1) mit einer Soll-Phase (PC1) zu liefern,
wobei die Detektionsmittel (MD) weiter konfiguriert sind, um
die Soll-Phase (PC1) und die bestimmte Phase (PI) des analogen Signals (SI3) zu vergleichen, und
wenn sich die Soll-Phase (PC1) und die bestimmte Phase (PI) des analogen Signals (SI3) unterscheiden, die Phase des analogen Signals (SI3) über die Einstellmittel (MR) einzustellen, bis eine Gleichheit der Soll-Phase (PC1) und der bestimmten Phase (PI) des analogen Signals (SI3) bis auf eine Toleranz erhalten wird.

9. Vorrichtung nach Anspruch 8, wobei die Einstellmittel (MR) einen komplementären Hybridkoppler (CH1) umfassen, der konfiguriert ist, um nach einem Leistungsteilermodus zu arbeiten, und mit dem ersten und dem zweiten Eingang (BE3, BE4) des Hybridkopplers (CH2) gekoppelt ist.

10. Vorrichtung nach Anspruch 8, wobei die Einstellmittel (MR) einen komplementären Hybridkoppler (CH1) umfassen, der konfiguriert ist, um nach einem Leistungsteilermodus zu arbeiten, und über eine Koppelstufe (EC1) mit dem ersten und dem zweiten Eingang (BE3, BE4) des Hybridkopplers (CH2) gekoppelt ist.

11. Übertragungspfad, umfassend
eine elektronische Detektionsvorrichtung (CH1, MD) nach einem der Ansprüche 5 bis 7 oder eine elektronische Einstellvorrichtung (CH1 , MD, CH2, MR) nach einem der Ansprüche 8 bis 10, und
eine Antenne (ANT1), die mit dem Hybridkoppler (CH2) gekoppelt ist.

12. Kommunikationsgerät, das mindestens einen Übertragungspfad (CT1) nach Anspruch 11 beinhaltet.

## Claims

1. Method for detecting a phase (PI) of an analog signal (SI3) via a hybrid coupler (CH2) operating in a power combiner mode, the hybrid coupler (CH2) comprising a first input (BE3) intended to receive said analog signal (SI3), a second input (BE4) intended to receive an additional analog signal (SI4) phase-shifted by 90° relative to the analog signal (SI3), a first output (BS3) providing an output signal (SS1), and a second output (BS4), the method being **characterised in that** it comprises:
an injection at the second output (BS4) of a test signal (ST1) having an initial test phase (PTI),
an iterative generation of a current test phase (PTC) for the test signal (ST1), from the initial test phase (PTI) to a final test phase (PTF) equal to the initial test phase (PTI) increased by at least part of a complete turn, with a measurement of the current peak value (AC1) of the output signal (SS1) in each iteration, and storing the current test phase (PTC) and the current peak value (AC1) as a maximum (Amax) or minimum (Amin) peak value, if there is not respectively a larger stored maximum peak value (Amax) or a smaller stored minimum peak value (Amin) than the current peak value (AC1), and
determining the phase (PI) of the analog signal (SI3) from the stored test phase (PTM).

2. Method according to claim 1, wherein the phase (PI) of the analog signal (SI3) is equal
to the stored test phase (PTM) if the stored test phase (PTM) corresponds to the stored maximum peak value (Amax), or
to the stored test phase (PTM) increased by 180° if the stored test phase (PTM) corresponds to the stored minimum peak value (Amin).

3. Method according to claim 1 or 2, wherein the final test phase (PTF) is the initial test phase (PTI) increased by a complete turn.

4. Method for adjusting the phase (PI) of analog signal (SI3) via a hybrid coupler (CH2) operating in a power combiner mode, comprising
determining the phase (PI) of the analog signal (SI3) by applying the method according to any one of the preceding claims,
a comparison between a setpoint phase (PC1) and the phase (PI) of the analog signal (SI3), and
if the setpoint phase (PC1) and the phase (PI) of the analog signal (SI3) determined are different, adjusting the phase of the analog signal (SI3) until the setpoint phase (PC1) and the phase (PI) of the analog signal (SI3) are equal to within one tolerance.

5. Electronic device for detecting a phase (PI) of an analog signal (SI3), comprising
a hybrid coupler (CH2) configured to operate in a power combiner mode and comprising a first input (BE3) intended to receive the analog signal (SI3), a second input (BE4) intended to receive an additional analog signal (SI4) phase-shifted by 90° relative to the analog signal, a first output (BS3) intended to provide an output signal (SS1), and a second output (BS4), the device being **characterised in that** it further comprises detection means (MD) configured to
inject at the second output (BS4) a test signal (ST1) having an initial test phase (PTI),
carry out an iterative generation of a current test phase (PTC) for the test signal (ST1), from the initial test phase (PTI) to a final test phase (PTF) equal to the initial test phase (PTI) increased by at least part of a complete turn, with a measurement of the current peak value (AC1) of the output signal (SS1) in each iteration, and to store the current test phase (PTC) and the current peak value (AC1) as a maximum (Amax) or minimum (Amin) peak value, if there is not respectively a larger stored maximum peak value (Amax) or a smaller stored minimum peak value (Amin) than the current peak value (AC1), and to determine the phase (PI) of the analog signal (SI3) as a function of the stored test phase (PTM).

6. Device according to claim 5, wherein the phase (PI) of the analog signal (SI3) is equal
to the stored test phase (PTM) if the stored test phase (PTM) corresponds to the stored maximum peak value (Amax), or
to the stored test phase (PTM) increased by 180° if the stored test phase (PTM) corresponds to the stored minimum peak value (Amin).

7. Device according to claim 5 or 6, wherein the final test phase (PTF) is the initial test phase (PTI) increased by a complete turn.

8. Device for adjusting the phase (PI) of an analog signal (SI3) via a hybrid coupler (CH2) operating in a power combiner mode, comprising
a detection device (CH2, MD) according to any one of claims 5 to 7 configured to determine the phase (PI) of the analog signal (SI3), and
adjustment means (MR) coupled to the hybrid coupler (CH2), and configured to supply the first input (BE3) with the analog signal (SI3), the second input (BE4) with the additional analog signal (SI4), and the detection means (MD) with a setpoint signal (SC1) having a setpoint phase (PC1),
the detection means (MD) also being configured to compare the setpoint phase (PC1) and the phase (PI) of the analog signal (SI3) determined, and
if the setpoint phase (PC1) and the phase (PI) of the analog signal (SI3) determined are different, adjust the phase of the analog signal (SI3) via the adjustment means (MR) until the setpoint phase (PC1) and the phase (PI) of the analog signal (SI3) determined are equal to within one tolerance.

9. Device according to claim 8, wherein the adjustment means (MR) comprise an additional hybrid coupler (CH1) configured to operate in a power divider mode and coupled to the first and second inputs (BE3, BE4) of the hybrid coupler (CH2).

10. Device according to claim 8, wherein the adjustment means (MR) comprise an additional hybrid coupler (CH1) configured to operate in a power divider mode and coupled to the first and second inputs (BE3, BE4) of the hybrid coupler (CH2) via a coupling stage.

11. Transmission path, comprising
an electronic detection device (CH1, MD) according to any one of claims 5 to 7 or an electronic adjustment device (CH1, MD, CH2, MR) according to any one of claims 8 to 10, and
an antenna (ANTI) coupled to the hybrid coupler (CH2).

12. Communication device including at least one transmission path (CT1) according to claim 11.
